(19) **Europäisches Patentamt**

**European Patent Office**

**Office européen des brevets**

(11) **EP 1 160 968 B1**

(12) **EUROPEAN PATENT SPECIFICATION**

(45) Date of publication and mention
of the grant of the patent:
**09.02.2005 Bulletin 2005/06**

(51) Int Cl.⁷: **H03C 3/40**

(21) Application number: **00401542.6**

(22) Date of filing: **31.05.2000**

(54) **Method and apparatus for transmitting a signal**

Verfahren und Vorrichtung zur Übertragung eines Signals

Méthode et dispositif pour transmettre un signal

(84) Designated Contracting States:
**AT BE CH CY DE DK ES FI FR GB GR IE IT LI LU
MC NL PT SE**
Designated Extension States:
**AL LT LV MK RO SI**

(43) Date of publication of application:
**05.12.2001 Bulletin 2001/49**

(73) Proprietor: **Freescale Semiconductor, Inc.
Austin, Texas 78735 (US)**

(72) Inventors:
• **Khlat, Nadim
31270 Cugnaux (FR)**

• **Chiron, Jean-Frédéric
31300 Toulouse (FR)**

(74) Representative: **Wharmby, Martin Angus
Freescale Semiconductor Inc.
c/o Impetus IP Limited
Grove House
Lutyens Close
Basingstoke, Hampshire RG24 8AG (GB)**

(56) References cited:
**EP-A- 0 999 645        WO-A-99/30424**

## Description

### Field of the Invention

The present invention relates to a communication system, and more particularly to a method and apparatus for transmitting a signal in such a communication system.

### Background of the Invention

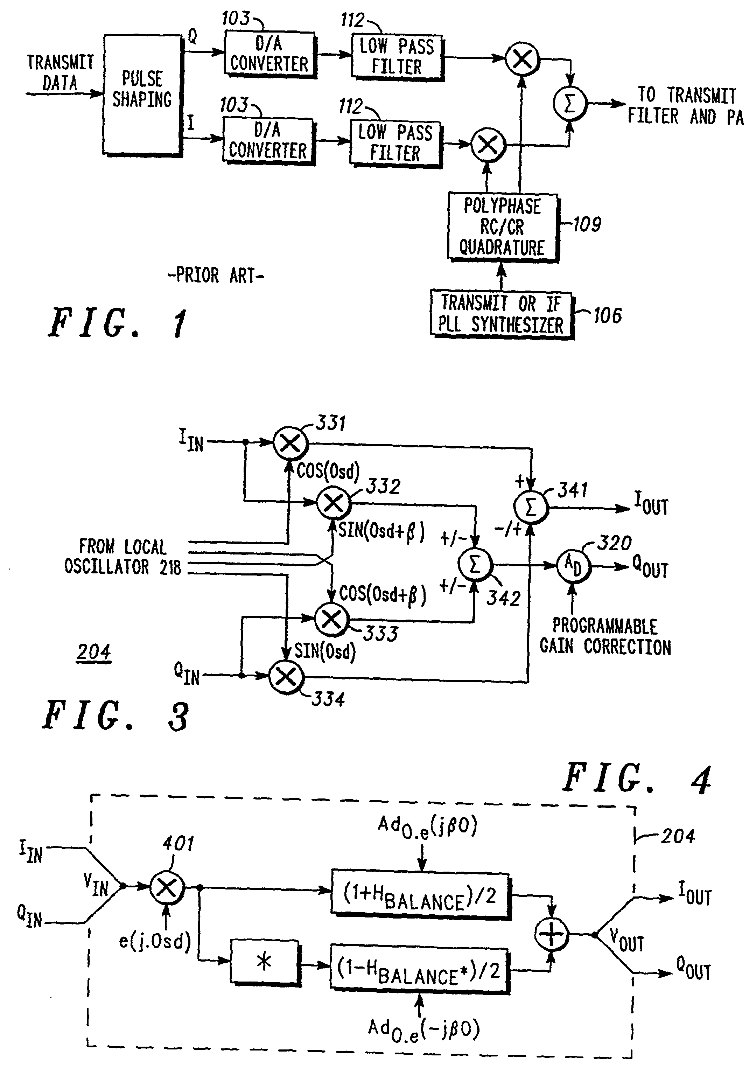

New cellular standards such as EDGE and EDGE phase II require transmitters with low error vector magnitude (EVM) in order to limit the link level degradation for high-speed data transmission. A prior art modulator is shown in FIG. 1. This type of modulator uses an In-Phase/Quadrature Phase (IQ) modulator with analog balancing using varactors and digital-to-analog (D/A) converters 103 to control the quadrature local oscillator (LO) network in order to minimize image components. As depicted in FIG. 1, most direct IQ modulators today use a local oscillator set at the selected RF channel and use a phase locked loop (PLL) synthesizer 106 with steps equal to the channel spacing (e. g., 200khz for GSM). In this implementation, the LO leakage is then centered directly at the RF channel (a typical value is in the range of 30-35 dB of LO leakage), as is the image component introduced by a gain/phase imbalance of the IQ modulator. A typical value of 30-35 dB of image rejection is achieved using a polyphase RC/CR quadrature network 109. Considering an image rejection of IMr = 35 dB as best case with an LO leakage of LO leak = 30dB, the total EVM achieved by this system is in the range of EVM = 4.28% (or EVM = 2.03% if the LO leakage is removed from the EVM calculation) under the assumptions of having a LO phase noise of 0.5 degrees rms, the third order intermodulations of the IQ baseband at -60 dBc and a power amplifier (PA) with a limited non-linearity.

An other prior art modulator showing a similar structure as used in the present application is known from EP-A-0 999 645.

### Brief Description of the Drawings

In order that the present invention may be better understood, an embodiment thereof will now be described by way of example only, with reference to the accompanying drawings in which:

FIG. 1 generally depicts a block diagram of a prior art IQ modulator;
FIG. 2 generally depicts a transmitter capable of operating in either a low IF (LIF) mode or in a very low IF (VLIF) mode in accordance with the invention;
FIG. 3 generally depicts a block diagram of a first order complex balanced multiplier suitable for use in the modulator of FIG. 2;
FIG. 4 generally depicts a block diagram similar to FIG. 3 depicting a mathematical model of a balanced multiplier suitable for use in the transmitter of FIG. 2;
FIG. 5 generally depicts a power spectrum of an EDGE 8PSK modulated signal and the generated image components when operating at Very Low IF;
FIG. 6 generally depicts an alternate implementation which combines a balanced complex multiplier with modulation phase mapping at a operating frequency equal to the data symbol rate in accordance with the invention;
FIG. 7 further depicts the phase accumulator of FIG. 6 in accordance with the invention; and
FIG. 8 generally depicts the digital quadrature local oscillator as shown in FIG. 2 in accordance with the invention.

### Detailed Description of a Preferred Embodiment

Stated generally, transmitter uses a digital very low IF with a digital complex balanced multiplier in conjunction with a fractional N synthesizer which reduces the impact of IQ quadrature circuitry imbalance and LO leakage in the overall error vector magnitude (EVM) budget while still meeting spectral mask purity requirements is disclosed. In addition, the presence of the digital transmit balanced complex multiplier offers the capability to perform a digital phase/amplitude pre-distortion adjustment as required.

Stated more specifically, in a first embodiment, a transmitter for use in a wireless communication system is provided according to the features of Claim 1. The balanced complex multiplier provides a gain and phase adjustment related to at least a component imbalance in the IQ modulator circuitry. Additionally, the gain and phase adjustment is performed at a specific frequency to produce the signal having a reduced IF LO leakage or at a plurality of frequencies to produce the signal having a reduced IF LO leakage.

The transmitter in this embodiment also includes a low IF value which is in the range of 2*channel spacing to 10*channel spacing. The balanced complex multiplier operates in either a 1X symbol rate mode or an oversampling mode and includes an AC coupling network which is implemented on the I and Q baseband outputs to reduce the level of IF LO leakage. The transmitter in this embodiment also includes a TX clean-up filter at the IF value which is implemented to reduce the image level and the IF LO leakage prior to transmission.

In an alternate embodiment a transmitter for use in a wireless communication system includes a balanced complex multiplier having as inputs I and Q signals and signals from a digital local oscillator (LO) and producing I and Q output signals at a first intermediate frequency (IF) and IQ modulator circuitry having as input the I and Q output signals at a very low IF value and a LO signal at a final transmit frequency and producing a signal having a reduced image level and a reduced LO leakage prior to transmission. In this embodiment, the very low IF value is in the range of the channel spacing/10 to the channel spacing/2 and the signal produced has a reduced image level displaced by twice the low IF value without compromising the output spectrum.

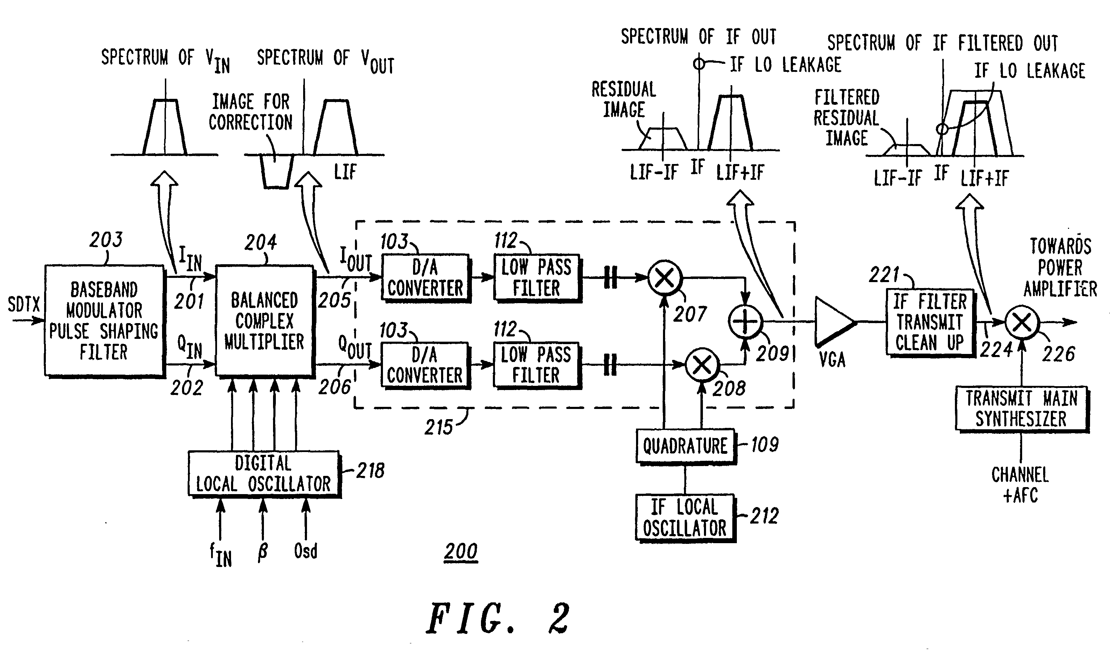

FIG. 2 generally depicts a block diagram of a transmitter 200 in accordance with the invention. As shown in FIG. 2, digital IQ input signals 201, 202 generated by a pulse shaping filter 203 from a serial data transmission (SDTX) are processed by a balanced complex multiplier 204 which is driven by signals output from a digital local oscillator (LO) 218 to produce digital IQ output signals 205, 206. As shown in FIG. 2, these signals 205, 206 are at a low IF as compared to the prior art transmitter implementation where these signals would reside at DC. These signals 205, 206 are then converted to analog signals via DACs 103 and low pass filtered via filters 112. The resulting analog I and Q signals drive respective quadrature IQ modulators 207, 208 where the local oscillator (LO) 212 is based on a fractional N synthesizer with fine tuning resolution.

As shown in FIG. 2, balanced complex multiplier 204 operates at the oversampling clock, i.e. at the same frequency as input signals 201 and 202, which normally for a communication system compatible with EDGE is 16 times higher than the symbol rate. Additionally, the balanced complex multiplier 204 provides several functions in accordance with the invention. First, it provides gain and phase imbalance correction of the IQ modulator circuitry 215 in order to reduce the image component produced by the circuitry 215. Second, it moves the I & Q signals to a shifted IF or in general adds a phase modulation $O_{sd}(t)$ or $2*pi*DIF*t$ in the particular case of Low IF or Very Low IF in order to offset the image component by $2*O_{sd}$ from the selected radio frequency (RF) transmit (TX) channel and to get additional image reduction due to the receive (RX) filter. It also moves the LO leakage at $O_{sd}$ in order to reduce the LO leakage contribution in the overall EVM. Finally, in an additional embodiment, it may be used to provide a partial AM/PM correction of the overall transmitter since it allows a phase component to be beneficially added to compensate for the overall phase distortion of the transmitter.

As shown in the preferred embodiment of FIG. 2, either a very low IF (VLIF) in the range of 20 to 80 kHz or a low IF (LIF) in the range of 1 to 4 MHz (nominally 2 MHz) is chosen to generate signals $I_{out}$ 205 and $Q_{out}$ 206. In the VLIF mode, after these signals are converted to analog and filtered, they are then up-converted to the final TX frequency. In the LIF mode, these signals are up-converted to the final TX frequency by a fixed IF in the range of 100 MHz where a TX IF filter 221 cleans up the spectrum by reducing the level of IF LO leakage which is 100 MHz + 2 MHz away (for the case of Low IF only). Filter 221 also reduces the level of the image at the frequency offset of 100 MHz + 4 MHz before the filtered output signal 224 is up-converted to the final transmit frequency using an upconverter mixer 226.

In this LIF transmitter topology, the choice of the 2 MHz IF with IQ modulator circuitry 215 allows the generation of a 100 MHz modulated signal with the imperfections of the IF LO leakage and the corresponding image moved in frequency away from the transmitted channel by a frequency offset of 2 MHz and 4 MHz respectively. In addition, the level of these imperfections is reduced. The IF LO leakage is reduced through the use of AC coupling on the Low IF IQ signals to filter the DC component. The image level is reduced through the use of the balanced complex multiplier 204 to compensate for the gain and phase mismatches. Further imperfections are filtered by the TX cleanup filter 221 such that the overall imperfections are below the minimum requirements of the spectrum mask; for example, -60 dBc for EDGE. The Low IF IQ modulator reduces the level of images at -35 dBc, such that the TX cleanup filter 221 only requires -35 dB of attenuation at 4 MHz frequency offset to achieve -60 dBc.

The balanced complex multiplier 204 using first order correction is shown in FIG. 3 in accordance with the invention. The complex balanced multiplier 204 comprises a Q-path gain adjustment means 320; first, second, third and fourth multipliers 331, 332, 333, 334; and first and second adder/subtractors 341, 342. Digital LO 218 receives a phase signal $O_{sd}$ from an IF LO generated by a two phase accumulators 801, 802 as shown in FIG. 8 which increments at a fixed step equal to a value of phase $2*pi*DIF/f_{in}$ where DIF is the programmed IF value and $f_{in}$ is the frequency of the operating clock. The phase output accumulates the fixed step value $2*pi*DIF/f_{in}$ at every clock cycle of $f_{in}$ to get the total phase $2*pi*DIF/f_{in}*n$ where n is the neme clock cycle used by the digital IF (e.g., if n=5, then 5 clock cycles have elapsed that have accumulated 5 values in the digital IF accumulator). As shown in FIG. 8, the Q-path accumulator loads the phase correction $\beta$ at the beginning of a transmission. The phase accumulators 801, 802 outputs an address to a ROM table 805 which outputs $\cos(O_{sd})$, $\sin(O_{sd})$, $\cos(O_{sd} + \beta)$ and $\sin(O_{sd} + \beta)$ signals, which are then applied to the second inputs of the first, second, third and fourth multipliers 331, 332, 333, 334 respectively. Additionally, the first and second multipliers 331, 332 have the digital I-path signal $I_{in}$ that are generated by the pulse shaping filters 203 applied to their first inputs, while the third and fourth multipliers 333, 334 have the digital Q-path signal $Q_{in}$ that are

generated by the pulse shaping filters 203 applied to their first inputs. The outputs of the first and fourth multipliers 331, 334 are applied as inputs to the first adder/subtractor 341 which outputs a digital baseband I signal while the outputs of the second and third multipliers 332, 333 are applied as inputs to the second adder/subtractor 342 which outputs a digital baseband Q signal $Q_{out}$.

The effect of the complex balanced multiplier 204 is to generate output I and Q signals $I_{out}$ and $Q_{out}$ from input signals $I_{in}$, $Q_{in}$ and $O_{sd}$, as set out in equation (1) below:

$$V_{out} = I_{out} + jQ_{out} = (I_{in} + jA_d e^{j\beta} Q_{in})e^{jO_{sd}} \qquad (1)$$

or

$$V_{out}(n) = \frac{1}{2}[V_{in}(n)e^{jO_{sd}(n)}(1 + Ad_0 e^{jb_0})] + \frac{1}{2}[V^*_{in}(n)e^{-jO_{sd}(n)}(1 - Ad_0 e^{-jb_0})] \qquad (2)$$

where $V_{in} = I_{in} + jQ_{in}$ and $V^*_{in} = I_{in} - jQ_{in}$ (where * stands for vector conjugate). This corresponds to:

$$I_{out}(n) = \cos(b_0)A(n)\cos(O_{sd}(n) + O(n)) \qquad (3)$$

$$Q_{out}(n) = Ad_0 \cos(b_0)A(n)\sin(O_{sd}(n)+O(n) + b_0). \qquad (4)$$

From equation (1), it can be seen that $Q_{in}$ may differ from what it is supposed to be because of relative imbalances between the I and Q paths by $1/A_d$ in gain and $-\beta$ in phase. The effect of the balanced complex multiplier 204 is to correct the imbalance as desired. Unfortunately, the imbalance between the paths will not be constant over frequency due to mismatches in filters 112. Thus, in this embodiment, the balanced complex multiplier 204 of FIG. 2 is only able to exactly balance the I and Q paths at a single frequency. Equation (2) can be expanded for multiple frequency correction, in alternate embodiments, to become:

$$V_{out}(n) = \frac{1}{2}[V_{in}(n)e^{jO_{sd}(n)}(1 + Ad_0 e^{jb_0})] + \frac{1}{2}[V^{*in}(n)e^{jO_{sd}(n)}(1 - Ad_0 e^{-jb_0})] +$$

$$\frac{1}{2}[V_{in}(n-1)e^{jO_{sd}(n)}(1 + Ad_1 e^{jb_1})] + \frac{1}{2}[V^*_{in}(n-1)e^{jO_{sd}(n)}(1 - Ad_1 e^{-jb_1})] + \ldots$$

$$\frac{1}{2}[V_{in}(n-k)e^{jO_{sd}(n)}(1 + Ad_k e^{jb_k})] + \frac{1}{2}[V^*_{in}(n-k)e^{jO_{sd}(n)}(1 - Ad_k e^{-jb_k})] + \qquad (5)$$

In order to fully describe the imbalance between the paths created by the differences in the analogue components contained in these paths, one must consider the imbalances as being caused by a filter having a Finite Impulse Response (FIR) given by equation (6) below:

$$H_{imbalance}(z) = \frac{1}{A_{d0}} \cdot e^{-j\beta_0} + \frac{1}{A_{d1}} \cdot e^{-j\beta_1} \cdot z^{-1} + \frac{1}{A_{d2}} \cdot e^{-j\beta_2} \cdot z^{-2} + \ldots \qquad (6)$$

Clearly, to counter the effect of such an FIR one needs to provide a filter or equivalent means having the response given by equation (7) below:

$$H_{balance}(z) = A_{d0} \cdot e^{+j\beta_0} + A_{d1} \cdot e^{+j\beta_1} \cdot z^{-1} + A_{d2} \cdot e^{-j\beta_2} \cdot z^{-2} + \ldots \qquad (7)$$

From equation (7), it is apparent that the first-order compensation provided by balanced complex multiplier 204 corresponds to the first term of $H_{balance}$. In order to provide higher-order compensation or balancing, one could provide a dedicated digital filter having an FIR to compensate for the imbalance up to as many orders as desired. However, it is preferable to re-use some of the elements of the complex multiplier contained within the digital VLIF mixer stage.

A model for balanced complex multiplier 204 is shown in FIG. 4. This is a mathematical vector representation of the IQ modulator with the presence of IQ mismatches, i.e. $H_{balance}$ not equal to 1. The first mixer 401 with the * is a representation of a balanced complex multiplier. With reference to this figure, when $H_{balance}$ from equation (7) is equal to 1, perfect balance exists and no image component is generated. However, when an imbalance exists, a path for the image component is generated through $1-H_{balance}$ in such a way as to compensate the created image component introduced by IQ modulator circuitry 215 as will be shown.

A model for IQ modulator circuitry 215 is given by equation (8):

$$S(t) = \frac{(V_{outm} + V^*{}_{outm})}{2} \tag{8}$$

where S(t) is the output of IQ modulator circuitry 215 which is a real signal and $V_{outm}$ is the equivalent output vector of IQ modulator circuitry 215. Given the presence of a gain $A_d$ and a phase mismatch of IQ modulator circuitry 215, then $V_{outm}$ can be expressed by:

$$V_{outm} = e^{j(\omega_{RF}t+O_{sd}(t))}[V_{inm} \frac{(Ade^{jb} - 1)}{2}] + e^{j(\omega_{RF}t+O_{sd}(t))}[V^*{}_{inm} \frac{(Ade^{jb} + 1)}{2}]. \tag{9}$$

Note that the first term represents the image component that will be at a phase offset of $+2O_{sd}$ (since $V_{sd}$ is already phase shifted by $+O_{sd}(t)$ by balanced complex multiplier 204) from the RF channel while the second term is the wanted channel centered at the RF channel (since $V^*{}_{inm}$ is phase shifted by $-O_{sd}(t)$).

Now, if balanced complex multiplier 204 and IQ modulator circuitry 215 driven by synthesiser 206 operating at $O_{sd}$, then the resulting output is:

$$V_{outm} = e^{j(\omega_{RF}t+2O_{sd}(t))}[V_{in} \frac{(Ade^{jb} - Ad_0e^{jb_0})}{2}] + e^{j(\omega_{RF}t)}[V^*{}_{in} \frac{(Ade^{jb} + Ad_0e^{-jb_0})}{2}] \tag{10}$$

Where $V_{in}$ is the input of the balanced complex multiplier 204 and $V_{inm}$ is the output of the balanced IQ multiplier. The first term represents the remaining image component at $2O_{sd}$ offset and is nulled if perfect balancing correction is performed, i.e. if $Ade^{jb} = Ad_0e^{jb_0}$. The second term is the wanted channel at zero offset multiplied by a gain factor, which in the case of perfect balancing is $Ad_0cos(b_0)$. This gain factor is dependent upon the gain and phase imbalance of IQ modulator circuitry 215 and can be compensated digitally by dividing $V_{in}$ by $Ad_0cos(b_0)$. The image rejection ration is then equal to:

$$\frac{Ade^{jb} + Ad_0e^{-jb_0}}{Ade^{jb} - Ad_0e^{jb_0}}. \tag{11}$$

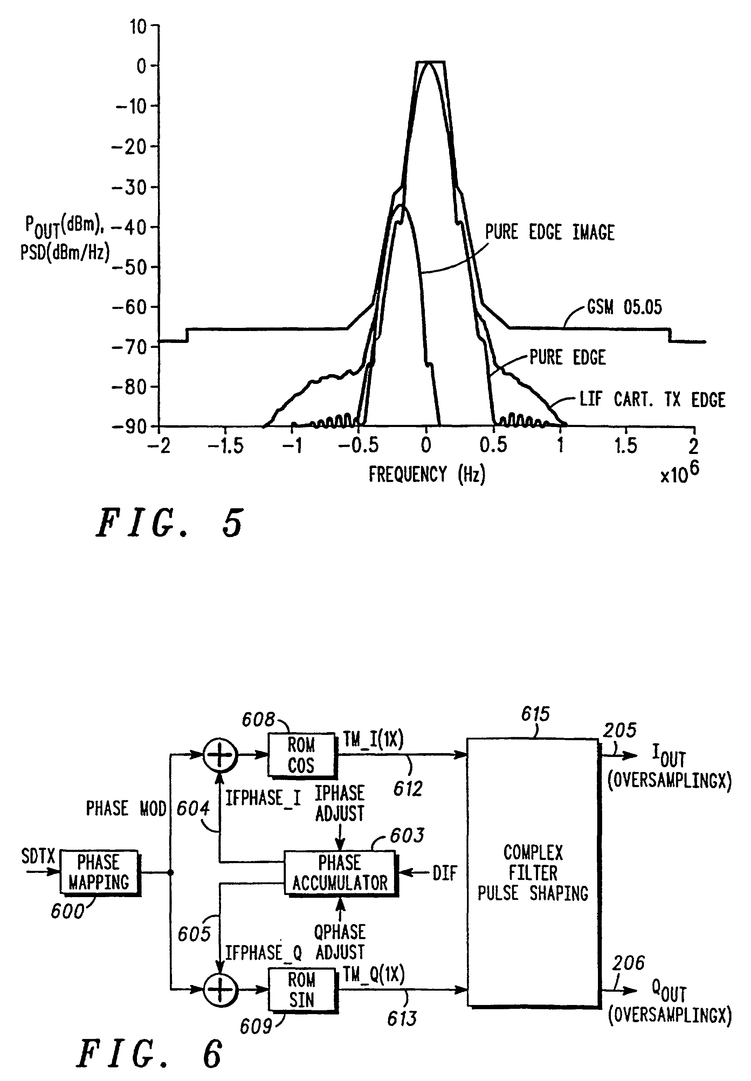

To verify the inventive concept, simulations were performed for certain scenarios. The first scenario is for a very low IF (i.e., $O_{sd} = 2\pi F_{fi}$). The model includes a D/A resolution of 10 bits, a 4th order Butterworth low pass filter at 800 kHz bandwidth, a non-linear IQ modulator specified by its second and third order rejection IM2 and IM3, a programmable synthesiser at $F_{fi}$ with a phase noise of 0.5 degrees rms, a linearised GMSK receive filter to measure the EVM and a non-linear power amplifier (PA). FIG. 5 generally depicts a very low IF transmit (TX) image and output channel for channel spectrum related to Enhanced Data rates for GSM Evolution (EDGE) modulation. As shown in FIG. 5, a very low IF with $F_{fi}$ = 100 kHz with an image rejection of 35 dB appearing at -200 kHz was implemented. Important to note is that the choice of the IF value is critical in order to optimize the reduction of the EVM and still meet the spectral mask as defined by the GSM 05.05 template shown in FIG. 5. It was found that the baseband non-linearity of the IQ modulator is critical for this system, mainly the IM3 since when operating at $F_{fi}$, the non-linearity modulation is shifted at 3 $F_{fi}$. Higher $F_{fi}$ means better EVM rejection, but higher sensitivity to IM3 for the modulator.

A comparison between a prior art IQ modulator and a very low IF (or Direct IQ modulator $F_{fi}$ = 0) using balanced complex multiplier 204 is shown below. In the prior art case, $F_{fi}$ = 0, IM2=IM3=60 dBc, image rejection = -35 dB, LO leakage = -30 dBc, LO phase noise = 0.5 degrees rms and a non-linear PA is implemented. In this example, EVM = 4.28 % (including LO leakage) or 2.03 % (without LO leakage). In an example in accordance with the invention where a direct IQ modulator is used with balanced complex multiplier 201, $F_{fi}$= 0, IM2=IM3=60 dBc, image rejection = -40 dB (due to digital correction), LO leakage = -30 dBc, LO phase noise = 0.5 degrees rms and a non-linear PA is implemented. In this example, EVM = 4.08 % (including LO leakage) or 1.51 % (without LO leakage). In another example in accordance with the invention, where a very low IF IQ modulator is used with balanced complex multiplier 201, $F_{fi}$ = 65 kHz, IM2=IM3=60 dBc, image rejection = -40 dB (due to digital correction), LO leakage = -30 dBc, LO phase noise = 0.5 degrees rms and a non-linear PA is implemented. In this example, EVM = 2.76 % (including LO leakage). As can be seen, the improvement of using the very low IF IQ modulator rather than a prior art modulator is in the range of 1.50 % on the EVM, which is 35 % improvement.

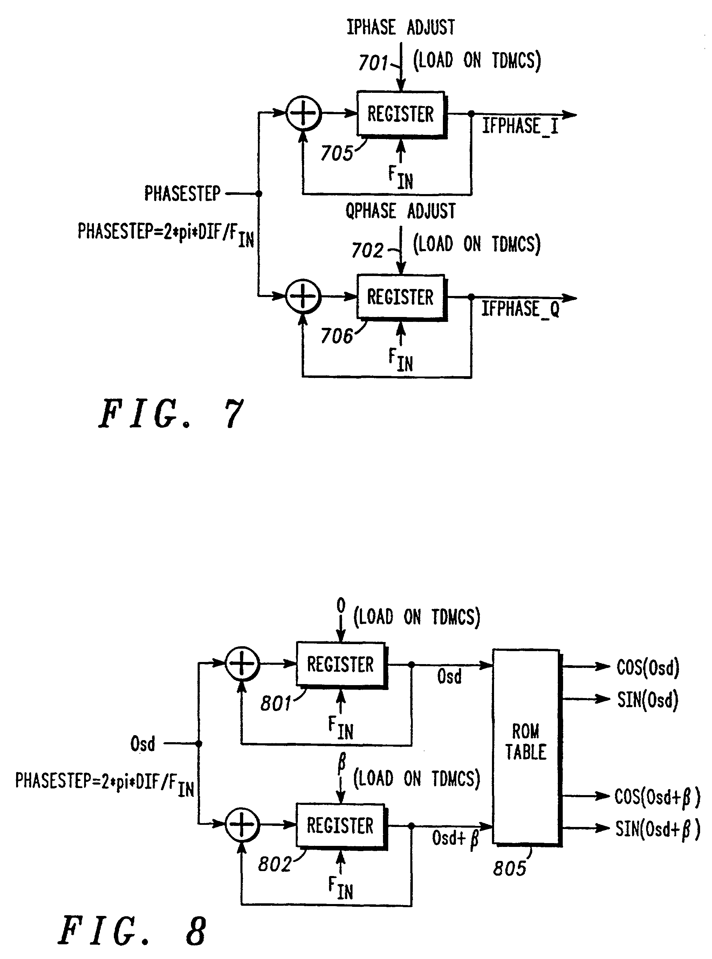

FIG. 6 generally depicts an alternate implementation which combines a balanced complex multiplier with modulation phase mapping at a operating frequency equal to the data symbol rate in accordance with the invention while FIG. 7 further depicts the phase accumulator of FIG. 6 in accordance with the invention. As shown in FIG. 6, the SDTX input is the input data to be transmitted at a bit rate $f_b$ and represents the data input to the phase mapping circuitry 600. The phase mapping mapped in block 600 for 3 bits is an equivalent phase symbol for an EDGE-compatible system (as an example) at a rate of 1X= $f_b$/3. At this point, the signals $I_{phase}$ adjust 701 and $Q_{phase\ adjust}$ 702 are added to the generated Low IF phase in phase accumulator 603 to generate two phase values Ifphase_I 604 and Ifphase_Q 605 which each address ROM tables 608, 609 respectively to generate a cos and sin signals labelled TM_I 612 and TM_Q 613. Signals TM_I 612 and TM_Q 613 are at the symbol rate 1X and are pulse shaped filtered and oversampled to a higher frequency clock with a Complex Filter 615 (Complex FIR or Complex IIR) since the spectrum of the input TM_I + j*TM_Q is frequency shifted to a Low IF value to produce signals $I_{out}$ 205 and $Q_{out}$ 206 in this alternate implementation in accordance with the invention.

While the invention has been particularly shown and described with reference to a particular embodiment, it will be understood by those skilled in the art that various changes in form and details may be made therein within the scope of the invention, as described in the accompanying claims. The corresponding structures, materials, acts and equivalents of all means or step plus function elements in the claims below are intended to include any structure, material, or acts for performing the functions in combination with other claimed elements as specifically claimed.

## Claims

1. A transmitter (200) for use in a wireless communication system, the transmitter comprising:

   IQ modulator means (215) having as input I and Q modulator input signals (205, 206) and a first local oscillator (212) signal, wherein the I and Q modulator input signals are modulated on the output signals in quadrature (109) of said local oscillator (212), for producing a modulated signal; and including filtering means (221) for filtering the modulated signals prior to transmission;

   **characterised by**
   balanced complex multiplier means (204) having as inputs I and Q data signals (201, 202) and further local oscillator signals from a digital local oscillator (218) for producing said I and Q modulator input signals (205, 206) at a first intermediate frequency related to the channel spacing frequency by a factor in the range of two to ten, such that image components and components due to leakage of said local oscillator signals are offset in frequency relative to wanted components of said I and Q modulator input signals and are filtered out by said filtering means (221).

2. A transmitter as claimed in claim 1, wherein said balanced complex multiplier means (204) provides a gain and phase adjustment related to at least a component imbalance in the IQ modulator means.

3. A transmitter as claimed in claim 2, wherein the gain and phase adjustment is performed at a specific frequency.

4. A transmitter as claimed in claim 2, wherein the gain and phase adjustment is performed at a plurality of frequencies.

5. A transmitter as claimed in any preceding claim, wherein said first intermediate frequency is in the range of twice channel spacing to ten times channel spacing.

6. A transmitter as claimed in any preceding claim, wherein the balanced complex multiplier operates in either a 1X symbol rate mode or an oversampling mode.

7. A transmitter as claimed in any preceding claim, wherein an AC coupling network is implemented on said I and Q data signals.

8. A transmitter as claimed in any preceding claim 1, wherein said filtering means (221) includes a clean-up filter at intermediate frequency.

9. A transmitter as claimed in any of claims 1 to 4, wherein said first local oscillator signal is substantially at a final transmit frequency.

10. A transmitter as claimed in claim 9, wherein said first intermediate frequency is in the range of one-tenth of the channel spacing to half the channel spacing.

11. A transmitter as claimed in claim 9, wherein said image component is displaced by twice said first intermediate frequency.

**Patentansprüche**

1. Sender (200) zur Verwendung in einem System zur drahtlosen Kommunikation, wobei der Sender umfasst:

    IQ-Modulatormittel (215), die als Eingaben I- und Q-Modulatoreingangssignale (205, 206) und ein erstes Lokaloszillatorsignal (212) aufweisen, wobei die I- und Q-Modulatoreingangssignale auf die Ausgangssignale in Quadratur (109) des Lokaloszillators (212) moduliert werden, um ein moduliertes Signal zu erzeugen; und Filtermittel (221) zum Filtern der modulierten Signale vor der Übertragung enthält;

    **gekennzeichnet durch**
    symmetrische komplexe Vervielfachermittel (204) ("balanced complex multiplier means"), die als Eingaben I-und Q-Datensignale (201, 202) und weiterhin Lokaloszillatorsignale von einem digitalen Lokaloszillator (218) aufweisen, um die I- und Q-Modulatoreingangssignale (206, 206) bei einer ersten Zwischenfrequenz zu erzeugen, die mit der Kanalabstandsfrequenz über einen Faktor im Bereich zwischen zwei und zehn in Beziehung steht, so dass Bildkomponenten ("image components") und Komponenten aufgrund eines Überkoppelns ("leakage") der Lokaloszillatorsignale relativ zu den gewünschten Komponenten der I- und Q-Modulatoreingangssignale in der Frequenz verschoben sind und **durch** die Filtermittel (221) ausgefiltert werden.

2. Sender nach Anspruch 1, wobei die symmetrischen komplexen Vervielfachermittel (204) eine Verstärkungs- und Phasenanpassung zur Verfügung stellen, die mindestens zu einem Komponentenungleichgewicht in den IQ-Modulatormitteln in Beziehung stehen.

3. Sender nach Anspruch 2, wobei die Verstärkungs- und Phasenanpassung bei einer bestimmten Frequenz durchgeführt wird.

4. Sender nach Anspruch 2, wobei die Verstärkungs- und Phasenanpassung bei einer Mehrzahl von Frequenzen durchgeführt wird.

5. Sender nach einem der vorhergehenden Ansprüche, wobei sich die erste Zwischenfrequenz im Bereich zwischen dem doppelten Kanalabstand und dem zehnfachen Kanalabstand befindet.

6. Sender nach einem der vorhergehenden Ansprüche, wobei der symmetrische komplexe Vervielfacher entweder in einem 1X-Symbolratenmodus oder in einem Überabtastmodus arbeitet.

7. Sender nach einem der vorhergehenden Ansprüche, wobei ein AC-Kopplungsnetzwerk auf den I- und Q-Datensignalen implementiert ist.

8. Sender nach einem der vorhergehenden Ansprüche, wobei die Filtermittel (221) einen Säuberungsfilter ("clean-up filter") bei der Zwischenfrequenz enthalten.

9. Sender nach einem der Ansprüche 1 bis 4, wobei das erste Lokaloszillatorsignal im Wesentlichen bei einer endgültigen Übertragungsfrequenz liegt.

**10.** Sender nach Anspruch 9, wobei die erste Zwischenfrequenz im Bereich zwischen einem Zehntel des Kanalabstands und der Hälfte des Kanalabstands liegt.

**11.** Sender nach Anspruch 9, wobei die Bildkomponente um das Zweifache der ersten Zwischenfrequenz verschoben ist.


**Revendications**

**1.** Emetteur (200) destiné à être utilisé dans un système de transmission sans fil, l'émetteur comprenant :

un moyen modulateur I Q (215) ayant comme signal d'entrée des signaux d'entrée de modulateur I et Q (205, 206) et un premier signal d'oscillateur local (212), où les signaux d'entrée de modulateur I et Q sont modulés sur les signaux de sortie en quadrature (109) dudit oscillateur local (212), afin de produire un signal modulé ; et comportant un moyen de filtrage (221) servant à filtrer les signaux modulés avant l'émission ;

   **caractérisé par** :

un moyen multiplicateur complexe équilibré (204) possédant comme signaux d'entrée des signaux de données I et Q (201, 202) et d'autres signaux d'oscillateur local venant d'un oscillateur local numérique (218) afin de produire lesdits signaux d'entrée de modulateur I et Q (205, 206) à une première fréquence intermédiaire liée à la fréquence d'espacement des canaux par un facteur compris dans un intervalle de 2 à 10, de sorte que les composantes images et les composantes dues aux fuites desdits signaux d'oscillateur local sont décalées en fréquence par rapport aux composantes voulues desdits signaux d'entrée de modulateur I et Q et sont éliminées par filtrage via ledit moyen de filtrage (221).

**2.** Emetteur selon la revendication 1, où ledit moyen multiplicateur complexe équilibré (204) produit un ajustement de gain et de phase qui est lié à au moins un déséquilibre des composantes dans le moyen modulateur I Q.

**3.** Emetteur selon la revendication 2, où l'ajustement de gain et de phase s'effectue à une fréquence spécifique.

**4.** Emetteur selon la revendication 2, où l'ajustement de gain et de phase s'effectue à plusieurs fréquences.

**5.** Emetteur selon l'une des revendications précédentes, où ladite première fréquence intermédiaire est dans l'intervalle de deux fois l'écartement des canaux à dix fois l'écartement des canaux.

**6.** Emetteur selon l'une des revendications précédentes, où le multiplicateur complexe équilibré agit dans un mode de débit de symboles (1X) ou dans un mode de suréchantillonnage.

**7.** Emetteur selon l'une quelconque des revendications précédentes, où un réseau de couplage en courant alternatif est mis en oeuvre sur lesdits signaux de données I et Q.

**8.** Emetteur selon l'une quelconque des revendications 1, où ledit moyen de filtrage (221) comporte un filtre de nettoyage à une fréquence intermédiaire.

**9.** Emetteur selon l'une quelconque des revendications 1 à 4, où ledit premier signal d'oscillateur local est sensiblement à une fréquence d'émission finale.

**10.** Emetteur selon la revendication 9, où ladite première fréquence intermédiaire est comprise à un intervalle d'un dixième de l'écartement des canaux à la moitié de l'écartement des canaux.

**11.** Emetteur selon la revendication 9, où ladite composante image est déplacée par deux fois ladite première fréquence intermédiaire.

-PRIOR ART-

# FIG. 1

# FIG. 3

# FIG. 4

SPECTRUM OF V$_{IN}$   SPECTRUM OF V$_{OUT}$

IMAGE FOR
CORRECTION

LIF

SPECTRUM OF IF OUT

IF LO LEAKAGE

RESIDUAL
IMAGE

LIF-IF  IF  LIF+IF

SPECTRUM OF IF FILTERED OUT

IF LO LEAKAGE

FILTERED
RESIDUAL
IMAGE

LIF-IF  IF  LIF+IF

*203*

SDTX → | BASEBAND MODULATOR PULSE SHAPING FILTER |

I$_{IN}$ *201*

Q$_{IN}$

*202*

*204*

| BALANCED COMPLEX MULTIPLIER |

I$_{OUT}$ *205*

Q$_{OUT}$ *206*

*103* | D/A CONVERTER |

*112* | LOW PASS FILTER |

*103* | D/A CONVERTER |

*112* | LOW PASS FILTER |

*207*

*208*

*209*

*215*

VGA

*221* | IF FILTER TRANSMIT CLEAN UP |

TOWARDS POWER AMPLIFIER

*224*

*226*

| DIGITAL LOCAL OSCILLATOR | —*218*

f$_{IN}$   β   Osd

| QUADRATURE | —*109*

| IF LOCAL OSCILLATOR | —*212*

*200*

| TRANSMIT MAIN SYNTHESIZER |

CHANNEL +AFC

EP 1 160 968 B1

*FIG. 2*

$F I G. \quad 5$

$F I G. \quad 6$

*FIG. 7*

*FIG. 8*